# FASCICULE DE BREVET EUROPEEN

(11) **EP 3 557 658 B1**
(45) Date de publication et mention de la délivrance du brevet: **14.07.2021**
(21) Numéro de dépôt: 19169030.4
(22) Date de dépôt: 12.04.2019
(51) Int. Cl.: C01B 25/30, H01M 50/409, H01M 10/052, H01M 10/0562, C01B 25/14

(54) **ELECTROLYTE SOLIDE DE BATTERIE**
FESTKÖRPERELEKTROLYT FÜR BATTERIE
SOLID ELECTROLYTE FOR BATTERY

(30) Priorité: 20.04.2018 FR 1853486
(43) Date de publication de la demande: 23.10.2019
(73) Titulaire: Commissariat à l'Energie Atomique et aux Energies Alternatives, 75015 Paris (FR); Institut Polytechnique de Grenoble, 38000 Grenoble (FR)
(72) Inventeur: MORIN, Pierrick, 38054 CEDEX 09 GRENOBLE (FR); BENAYAD, Anass, 38054 GRENOBLE Cedex 09 (FR); BOUCHET, Renaud, 38700 LA TRONCHE (FR); LE VAN-JODIN, Lucie, 54000 NANCY (FR)
(74) Mandataire: Decobert, Jean-Pascal

(56) Documents cités:
- EP-A1- 2 937 929
- WO-A1-2015/158607
- JP-B2- 4 016 344
- US-B1- 6 818 356
- KEIICHI MINAMI ET AL: "Electrical and electrochemical properties of glass-ceramic electrolytes in the systems Li2S-P2S5-P2S3 and Li2S-P2S5-P2O5", SOLID STATE IONICS, vol. 192, no. 1, 9 juillet 2010 (2010-07-09), pages 122-125, XP055544918, NL ISSN: 0167-2738, DOI: 10.1016/j.ssi.2010.06.018
- RENJIE CHEN ET AL: "The pursuit of solid-state electrolytes for lithium batteries: from comprehensive insight to emerging horizons", MATER. HORIZ., vol. 3, no. 6, 15 août 2016 (2016-08-15), pages 487-516, XP055543279, ISSN: 2051-6347, DOI: 10.1039/C6MH00218H

## Description

### DOMAINE DE L'INVENTION

La présente invention concerne les dispositifs dans le domaine du stockage d'énergie par voie électrochimique. Cela inclut les dispositifs du type batterie, utilisant un électrolyte solide, notamment les microbatteries du domaine de la micro-électronique.

L'invention trouve pour application avantageuse, mais non limitative, la fabrication de dispositifs microélectroniques. Par dispositif microélectronique, on entend tout type de dispositif réalisé avec les moyens de la microélectronique. Ces dispositifs englobent notamment en plus des dispositifs à finalité purement électronique dont mémoires et capacités mais aussi éventuellement des dispositifs plus complexes.

### ARRIERE-PLAN TECHNOLOGIQUE

Les microbatteries fonctionnent globalement de la même manière qu'un accumulateur conventionnel, à savoir par échange d'ions (généralement Li⁺) entre deux électrodes (une anode et une cathode) au travers d'un électrolyte. Les microbatteries sont cependant spécifiques en ce qu'elles sont uniquement composées de matériaux solides, de préférence des couches minces déposées par voie physique. On dispose d'une épaisseur totale faible, par exemple de l'ordre de quelques dizaines de microns permettant une miniaturisation des composants tout en supprimant tout risque de fuite de par l'absence de composants liquides. L'électrolyte solide permet aussi d'avoir recours à du lithium métallique comme électrode négative ce qui est proscrit pour des batteries à électrolyte liquide.

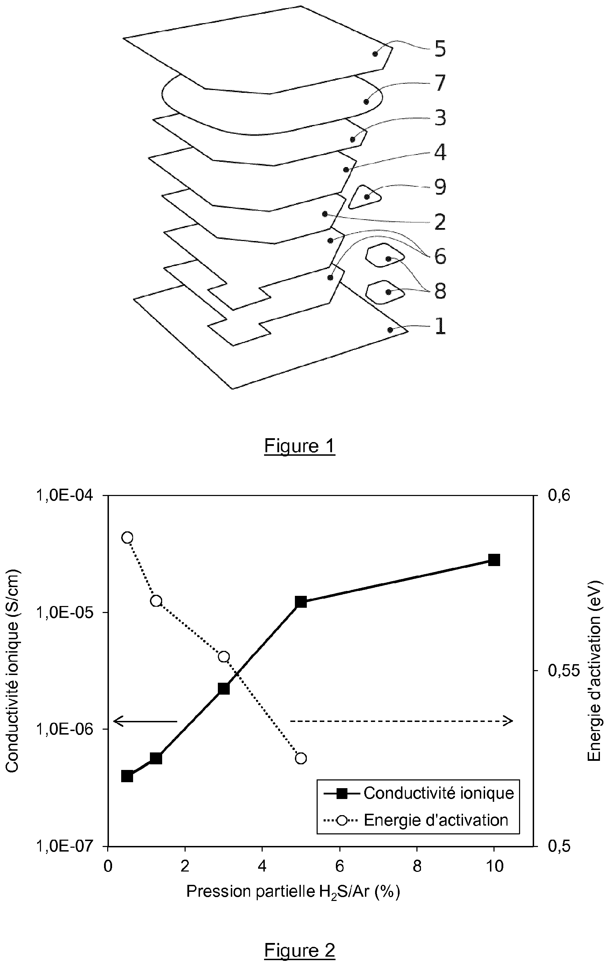

En se référant à la figure 1, de telles microbatteries sont de manière générale réalisées par des dépôts successifs sur un substrat 1 d'un premier collecteur de courant (ici en deux couches 6,8), d'une première électrode 2, d'un électrolyte solide (ou conducteur ionique) 4, d'une deuxième électrode 3, et d'un deuxième collecteur de courant 7. Une encapsulation 5, par le biais de dépôt de couches supplémentaires, ou par report de capot, est souvent nécessaire pour protéger le système de la réactivité chimique avec l'oxygène et la vapeur d'eau. Chaque partie d'électrodes est raccordée électriquement vers l'extérieur de l'encapsulation par l'intermédiaire d'éléments de raccordement 8,9, généralement via les collecteurs 6,7. Les collecteurs de courant sont facultatifs.

La migration d'un ou plusieurs ions entre les deux électrodes à travers l'électrolyte permet, soit de stocker de l'énergie, soit de la délivrer vers un circuit externe. La qualité de cette migration est fondamentale pour l'efficacité de la microbatterie. En particulier, la réduction de la résistance interne est cruciale. Plusieurs origines de cette résistance ont été identifiées, la principale étant la résistance ionique de la couche d'électrolyte solide qui est caractérisée par sa conductivité ionique intrinsèque. En effet, plus la conductivité est élevée, plus les ions (Li⁺) se déplacent facilement entre les deux électrodes par phénomènes de migration électrique.

La publication brevet US5338625 a proposé dans ce contexte un matériau d'électrolyte solide sous forme de LiPON. C'est un matériau amorphe, composé de lithium, de phosphore, d'oxygène et d'azote. Le composé précis qui y est décrit est le LiₓPO_{y}N_{z} avec x-2,8, 0,16<z<0,46, 2y=3z -7,8. Sa conductivité est donnée à 1,6x10⁻⁶ S/cm. Dans un souci de constante amélioration, on a ensuite cherché à améliorer encore le niveau de conductivité ionique. Une première approche a été d'augmenter le nombre de porteurs de charge Li⁺ en produisant le LiPON avec des cibles dites « surlithiées ». Une autre approche est celle présentée dans la publication brevet US6818356 B1 avec un électrolyte solide sous forme de Li_{w}POₓN_{y}S_{z} avec 2.9 < w < 3.8, 0.13 < y < 0.46 et 0 < z <0.2. La fabrication est calquée sur celle du LiPON en utilisant soit un gaz réactif soufré (typiquement un mélange N₂+H₂S) soit en disposant des morceaux de composés soufrés sur une cible de Li₃PO₄. Les résultats affirmés dans cette publication brevet sont une augmentation de conductivité du LiPON jusqu'à 40 % pour un ratio S/P égal à 0,15.

L'article Minami et al. "Electrical and electrochemical properties of glass-ceramic electrolytes in the systems Li2S-P2S5-P2S3 and Li2S-P2S5-P2O5", Solid State lonics, vol. 192, no. 1, 9 juillet 2010, pages 122-125 divulgue un électrolyte à l'état solide pour une batterie au lithium ayant la composition Li_{2,33}PO_{0,83}S_{2,83}.

Ainsi, les électrolytes basés sur le LiPON paraissent les plus prometteurs pour les batteries à conducteur ionique solide. Pourtant, il existe un besoin d'améliorer encore la conductivité ionique, et plus généralement les caractéristiques électriques, des électrolytes solides. Il semble en effet que l'ajout de soufre dans le LiPON ne permet pas d'atteindre l'augmentation de conductivité ionique espérée.

C'est un objet de l'invention que de pallier au moins en partie les inconvénients des techniques actuelles.

### RESUME DE L'INVENTION

L'invention concerne un électrolyte solide, une méthode pour sa préparation et une utilisation dudit électrolyte solide tels que définis dans les revendications annexées.

Alors que les techniques actuelles s'orientent vers des électrolytes du type LiPON et ne considèrent le soufre que comme un apport potentiel en association intime avec l'azote du LiPON, le demandeur a constaté que cette orientation est un préjugé exagérément favorable au LiPON.

Il est proposé, selon la présente invention, d'employer le souffre, en tant que tel, comme élément d'amélioration des propriétés de l'électrolyte (en particulier la conductivité ionique des ions Li⁺). Le demandeur a en effet constaté que les niveaux de conductivité ionique atteints par le LiPONS dans des microbatteries ne sont en pratique, pas aussi satisfaisants qu'espérés. D'une part, de manière non conventionnelle, l'invention s'écarte du LiPON, en supprimant l'azote dans l'électrolyte. D'autre part, elle révèle l'attrait propre (sans présence d'azote) du soufre pour accroitre la conductivité ionique des ions Li⁺ et non pas seulement son intérêt, tout relatif, comme adjuvant à l'azote.

De manière également surprenante, les résultats du demandeur montrent aussi que le LiPOS offre une réduction de l'énergie d'activation de la couche d'électrolyte. Dans le même temps que ces résultats avantageux, la conductivité électronique de la couche n'augmente pas exagérément, restant d'un ordre de grandeur six fois plus petit que la conductivité ionique, ce qui est tout à fait acceptable pour des microbatteries.

Un autre aspect séparable de la présente invention concerne une batterie, de préférence une microbatterie, comprenant un électrolyte tel qu'indiqué ci-dessus. Cette batterie est de préférence « tout solide ». Elle présente en règle générale en empilement sur une face d'un substrat :
- un premier collecteur de courant,
- une première électrode positive,
- l'électrolyte solide,
- une deuxième électrode négative, classiquement une couche de Lithium métal, faisant office de collecteur de courant.
- un deuxième collecteur de courant e/ou une ou plusieurs couches d'encapsulation.

Un autre aspect séparable de la présente invention concerne un procédé de réalisation d'un électrolyte comprenant une étape de dépôt physique en phase vapeur d'une couche d'électrolyte à partir d'une cible de Li₃PO₄, pulvérisée sous atmosphère réactive, de préférence exempte d'azote, et comprenant au moins un gaz soufré, de manière à obtenir une couche comprenant du LiₓPO_{y}S_{z}.

Un autre aspect séparable de l'invention concerne une utilisation de LiₓPO_{y}S_{z} en absence d'azote, avec 0<z≤3, pour la réalisation d'un électrolyte solide.

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
- la FIGURE 1 présente un exemple de structure de microbatterie en vue éclatée ;
- la FIGURE 2 présente deux courbes de caractéristiques électriques (conductivité ionique et énergie d'activation) d'un électrolyte obtenu grâce à l'invention, suivant plusieurs cas de teneur en soufre ;
- la FIGURE 3 présente une courbe d'évolution de la conductivité électronique d'un électrolyte obtenu grâce à l'invention, suivant plusieurs cas de teneur en soufre ;
- La FIGURE 4 donne une évolution de la composition du produit selon la teneur en soufre.

Les dessins sont donnés à titre d'exemples et ne sont pas limitatifs de l'invention.

### DESCRIPTION DETAILLEE

Avant d'entamer une revue détaillée de modes de réalisation de l'invention, sont énoncées ci-après des caractéristiques purement optionnelles qui peuvent éventuellement être utilisées en association ou alternativement :
- la couche consiste en du LiₓPO_{y}S_{z} avec 0 < z ≤ 3 ;
- éventuellement, mais non limitativement, z ≤ 2 ;
- 2.1 ≤ x ≤ 2.4 et 1 ≤ y ≤ 4.
- 3.7 ≤ y +z ≤ 4.1, et de préférence y + z = 4.
- l'électrolyte peut comprendre au moins une couche tampon sur au moins une face de la couche de LiₓPO_{y}S_{z} ;
- Selon un mode de réalisation, au moins une couche tampon comprend du LiPON ;
- Optionnellement, une couche tampon est comprise sur chaque face de la au moins une couche de LiₓPO_{y}S_{z}.
- de préférence, z est tel que 0.06 ≤ z ;
- avantageusement, x, y et z sont tels que la conductivité ionique est supérieure ou égale à 10⁻⁶ S/cm ;
- le taux de gaz soufré dans l'atmosphère est compris entre 0.5 et 15%, et est avantageusement inférieur ou égal à 10% voire à 5%.

La présente invention peut s'appliquer à la formation d'une microbatterie de structure conventionnelle et notamment à celle telle qu'illustrée en figure 1 précédemment introduite et qui est réalisée par l'empilement successif des couches suivantes :
- un substrat 1 ;
- un premier collecteur de courant 6, ici en deux couches de matériaux différents ; le raccordement de ce collecteur vers l'extérieur de la couche d'encapsulation peut être opéré par un premier élément de raccordement 8 ;
- une première électrode (cathode) 2 ;
- un électrolyte 4 ;
- une deuxième électrode (anode) 3 ;
- un deuxième collecteur de courant 7 ; le raccordement de ce collecteur avec l'extérieur de la couche d'encapsulation peut être opéré par un deuxième élément de raccordement 9 ;
- un élément d'encapsulation 5.

La spécificité des batteries « tout-solide » est de posséder un électrolyte 4 solide. Le rôle de cet électrolyte 4 est d'assurer le transport des ions lithium d'une électrode à l'autre de la batterie tout en bloquant le passage des électrons. Le mode de réalisation le plus couramment utilisé pour la réalisation de cet électrolyte 4 est la pulvérisation cathodique d'une cible sous vide.

Le principe de fonctionnement d'une microbatterie repose sur le principe d'oxydo-réduction d'ions lithium transitant entre un matériau d'anode 3 et un matériau de cathode 2 par l'électrolyte 4. Les électrons échangés lors de ces réactions transitent par un circuit extérieur assurant de ce fait la charge ou la décharge de la batterie.

L'apport de lithium dans la structure peut se faire soit par l'emploi direct d'une couche de lithium métallique comme anode 3 et on parle dans ce cas de « batterie lithium », soit par l'utilisation d'au moins un matériau d'électrode lithié et on parle dans ce cas de « batterie Li-ion ».

Selon l'invention, un électrolyte 4 solide comprenant une couche comprenant du LiₓPO_{y}S_{z} présente des propriétés de conductivité ionique particulièrement intéressantes. Les valeurs x, y et z sont des fractions molaires. Ces valeurs sont préférentiellement déterminées par analyses XPS (Spectroscopie Photoélectronique à rayons X couplée avec une abrasion GCIB (Gas Cluster Ion Beam). De préférence, l'indice z est choisi tel que 0 < z ≤ 3 et avantageusement tel que 0.06 ≤ z; suivant un mode de réalisation, pour limiter l'augmentation de la conductivité électronique, on choisit z tel que z ≤ 3 et de préférence z ≤ 2.

En ce qui concerne les indices x et y, on peut les fixer dans les gammes suivantes de sorte à obtenir des stœchiométries acceptables : 2.1 ≤ x ≤ 2.4 et 1 ≤ y ≤ 4. De préférence, y + z est égal à 4 ou est pour le moins compris entre 3,7 et 4,1.

De préférence, l'électrolyte 4 ne comprend qu'une seule couche, comprenant du LiₓPO_{y}S_{z}. Par ailleurs, même s'il n'est pas exclu que cette couche comprenne d'autres éléments chimiques, un mode de réalisation avantageux est qu'elle soit uniquement formée en LiₓPO_{y}S_{z}.

La couche comprenant du LiₓPO_{y}S_{z} selon l'invention ne contient pas d'azote mais contient une proportion non nulle et contrôlée de soufre. Toutefois, la conductivité ionique est avantageusement supérieure à la conductivité ionique des électrolytes de l'état de l'art. Préférentiellement, les indices x, y et z sont choisis de sorte que l'électrolyte possède une conductivité ionique supérieure ou égale à 10⁻⁶S/cm, voire à 10⁻⁵S/cm.

L'électrolyte solide selon l'invention est avantageusement amorphe.

A titre indicatif, le rôle, la nature chimique et les épaisseurs typiques de chaque couche d'une microbatterie, réalisable avec un électrolyte précédemment décrit, sont exposés ci-dessous:
- les collecteurs de courant sont notamment métalliques et peuvent être par exemple à base de Pt, Cr, Au, Ti, W, Mo, Ni. Les épaisseurs de ces collecteurs de courant sont préférentiellement comprises entre 100 nm et 1µm, généralement 250 nm. Ils servent à conduire le courant de façon homogène jusqu'à l'électrode 2, 3 avec laquelle ils sont en continuité électrique.
- La cathode 2 ou l'électrode positive peut être constituée de LiCoO₂, LiNiO₂, LiMn₂O₄, CuS, CuS₂, WO_{y}S_{z}, TiO_{y}S_{z}, LiTiS₂, Li₃TiS₃, V₂O₅. Selon les matériaux choisis, un recuit thermique peut être nécessaire pour augmenter la cristallisation des films et leur propriété d'insertion. C'est notamment le cas pour les oxydes lithiés. Néanmoins, certains matériaux amorphes, notamment des oxysulfures de titane, ne nécessitent pas un tel traitement tout en permettant une insertion élevée d'ions lithium. L'épaisseur de la cathode 2 est préférentiellement comprise entre 1µm et 25µm. La cathode 2 est le lieu de la réduction du lithium lors de la décharge de la microbatterie et de l'oxydation de celui-ci en charge
- L'électrolyte 4 selon l'invention est tel que décrit ci-dessus. L'épaisseur peut notamment être, comme testé par le demandeur, de 1,4µm, elle peut varier par exemple entre 500 nm et 3µm, voire au-delà.
- L'anode 3 peut être du lithium métallique déposé par évaporation thermique, un alliage métallique à base de lithium ou bien un composé d'insertion (SiTON, SnNₓ, InNₓ, Si, Li₄Ti₅O₁₂, SnO₂...). Il existe également des microbatteries sans anode appelées Li-free. Dans ce cas, une couche de métal, bloquant le lithium, est déposée. Le lithium initialement contenu dans l'électrode positive vient alors se déposer sur cette couche qui est ici assimilée à une électrode. L'épaisseur de l'anode 3 est préférentiellement comprise entre 100 nm et 10 µm. L'anode 3 est le siège de l'oxydation du Lithium lors de la décharge de la microbatterie et de la réduction lors de la charge.

Selon un mode de réalisation, l'empilement décrit ci-dessus est encapsulé. L'encapsulation 6 a pour objet de protéger l'empilement actif de l'environnement extérieur et spécifiquement de l'humidité. Différentes stratégies peuvent être utilisées : encapsulation à partir de couches minces, encapsulation à partir de co-laminés, ou encore encapsulation par capotage, tel que par exemple un capot en verre maintenu par du parafilm.

Selon un autre aspect, l'invention concerne un procédé de fabrication d'un électrolyte tel que décrit ci-dessus. Le procédé selon l'invention comprend une étape de dépôt de la couche comprenant du LiₓPO_{y}S_{z} en phase vapeur. Ce dépôt se fait à partir d'une cible de type Li₃PO₄. Plus précisément, le dépôt de LiPOS peut être réalisé par pulvérisation cathodique avantageusement, du type « RF sputtering » magnetron. Le lithium, le phosphore et l'oxygène sont apportés au moins en partie par la cible. La stœchiométrie des couches obtenues est en relation directe avec la pression partielle de gaz réactif introduit. Ce dernier comprend ici du soufre.

Contrairement au procédé de l'état de la technique, l'azote n'est pas intégré dans la couche comprenant du LiₓPO_{y}S_{z}. Suivant un mode de réalisation, l'absence d'azote est obtenue en utilisant une atmosphère de pulvérisation exempte d'azote. Il peut par exemple s'agir d'un mélange d'argon et de H₂S.

Avec la présente invention la composition des films déposés est contrôlée notamment par la puissance, la pression, le gaz utilisé, préférentiellement réglés directement sur le dispositif de dépôt.

Préférentiellement, le débit du gaz ou du mélange de gaz est compris entre 20 et 100 sccm, par exemple 80 sccm.

Avantageusement, la pression dans la chambre est comprise entre 0,5 et 2 Pa, préférentiellement égale à 0.7 Pa.

On comprend que l'on peut faire varier la proportion de soufre dans l'électrolyte selon la pression partielle de gaz soufré dans l'atmosphère de pulvérisation.

### Exemple : Dépôt d'un électrolyte selon l'invention et mesure de ses performances pour plusieurs proportions stœchiométriques

L'électrolyte en couche mince est déposé avec les paramètres suivants :
- la cible utilisée est Li₃PO₄;
- on réalise une pulvérisation cathodique RF magnetron sur un substrat de six pouces de diamètre fait de silicium avec des barrières SiO₂ et Si₃N₄. Le dépôt de LiPOS est opéré entre deux couches de titane chacune de 250 nm d'épaisseur également déposées par dépôt physique en phase vapeur «PVD », de sorte à former une structure Titane/électrolyte/Titane ;
- puissance : 350W (1.9W/cm²) ;
- Atmosphère du dépôt de LiPOS : (1-t)Ar + tH₂S avec 0 < t < 0.1 ;
- débit de gaz au total : 80 sccm ;
- durée de la pulvérisation : 4 heures et 45 minutes

Les tests du demandeur ont été effectués selon les paramètres ci-dessus avec différents taux de H₂S pour faire varier la proportion de soufre dans l'électrolyte selon la pression partielle de gaz soufré dans l'atmosphère de pulvérisation, correspondant au paramètre t indiqué ci-dessus, pour des valeurs de t égales à 0.005, 0.0125, 0.03, 0.05 et 0.1, ce qui correspond respectivement à une teneur en soufre dans l'atmosphère de pulvérisation de 0.5%, 1,25%, 3%, 5% et 10%. Un test a été opéré à titre de référence avec un taux de 0% (absence de soufre lors de la pulvérisation, soit t = 0)).

La conductivité ionique a été mesurée par spectroscopie d'impédance électrochimique. Le demandeur a pu en déduire l'évolution, pour cinq valeurs de t, des valeurs de conductivité et d'énergie d'activation par les courbes apparaissant à la figure 2. L'abscisse reflète la teneur en soufre en proportion atomique dans le LiPOS obtenu ; l'ordonnée indiquée à gauche correspond à la conductivité ionique en S/cm et son évolution est révélée par la courbe en trait plein ; l'ordonnée indiquée à droite correspond à l'énergie d'activation en eV et correspond à la courbe en trait pointillé.

La conductivité ionique va croissant avec l'augmentation de la teneur en soufre, dès que sa proportion est non nulle, et son maximum est obtenu à 2.8 .10⁻⁵ S/cm pour une pression partielle de 10% de H₂S dans l'atmosphère de dépôt.

On remarque également que l'augmentation de la conductivité ionique s'accompagne d'une diminution de leur énergie d'activation, phénomène également bienvenu dans l'amélioration des performances de l'électrolyte.

Les compositions mesurées donnent les stœchiométries résumées dans le tableau qui suit :

| **TAUX H₂S (%)** | **STOECHIOMETRIE** |
|---|---|
| 0.5 | Li_{2.39}PO_{4.04}S_{0.02} |
| 1.25 | Li_{2.36}PO_{3.49}S_{0.45} |
| 3 | Li_{2.15}PO_{2.13}S_{1.58} |
| 5 | Li_{2.12}PO_{1.80}S_{1.91} |
| 10 | Li_{2.27}PO_{1.61}S_{2.13} |

On remarque que l'ajout de soufre se fait principalement au détriment de l'oxygène, allant dans le sens d'un mécanisme de substitution entre ces deux éléments.

Il peut être souhaitable de maintenir la teneur en soufre en deçà d'une limite, de préférence telle que z ≤ 2, de sorte à ne pas obtenir une couche trop rugueuse, la rugosité augmentant avec la teneur en soufre selon les observations du demandeur. On peut constater une fissuration sur la couche d'électrolyte qui peut créer des courts-circuits dans ce cas, limitant la fiabilité électrique. En complément ou en alternative pour limiter la rugosité de la couche de LiPOS, on peut utiliser une pression plus élevée et/ou une puissance plus faible lors de sa fabrication pour réduire la vitesse de dépôt.

Une autre possibilité, éventuellement combinable aux enseignements donnés précédemment, est d'associer au moins une couche tampon à la couche de LiPOS, de sorte qu'une face, au moins, de la couche de LiPOS soit au contact d'une face de la couche tampon. Avantageusement, les deux faces de la couche de LiPOS sont chacune recouverte d'une couche tampon de sorte à encadrer le LiPOS. Cette solution permet au moins l'un des effets suivants :
- blocage de la conductivité électronique ;
- formation d'une interface avec les électrodes avec une meilleure comptabilité chimique ;
- amélioration de la résistance mécanique ;
- protection du LiPOS, notamment pour l'étanchéité à l'eau.

Dans ce contexte, la ou les couches tampon peuvent être en LiPON.

L'épaisseur peut par exemple être comprise entre 10 et 200 nm.

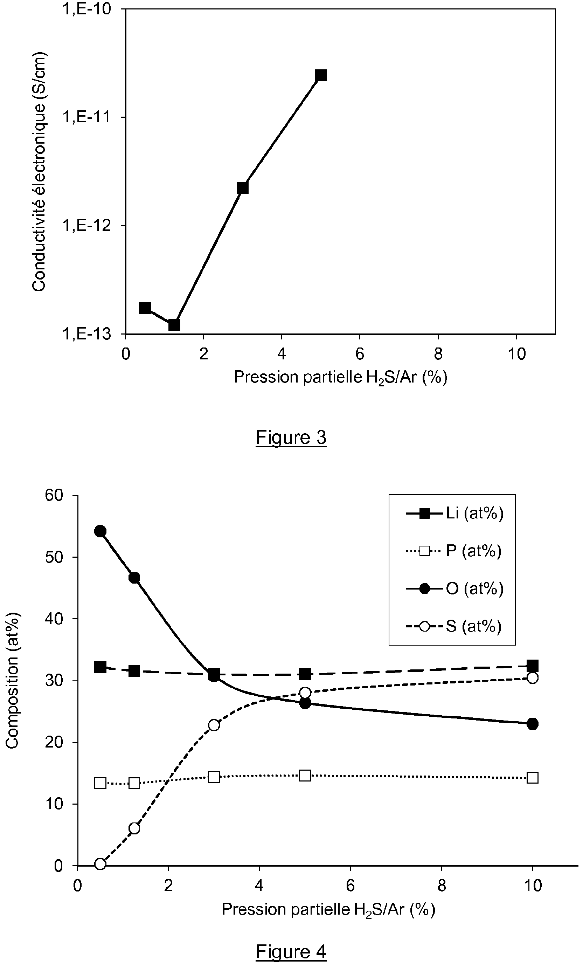

La figure 3 révèle l'évolution de la conductivité électronique en S/cm en fonction des cinq niveaux d'apport en soufre obtenus ici révélée par le taux de H₂S sur Argon dans l'atmosphère de pulvérisation. Généralement, une conductivité électronique la plus faible possible est préférable ; dans le cas présent, elle a tendance à augmenter avec la teneur en soufre mais, alors que l'on aurait pu penser que cette augmentation était rédhibitoire pour une utilisation du LiPOS à titre d'électrolyte, il s'avère que la conductivité électronique reste cependant suffisamment faible, même avec des taux élevés de soufre. Dans le cas des mesures effectuées, la conductivité électronique mesurée avec un taux de 5% de H₂S dans l'atmosphère de dépôt et de l'ordre de 2.10⁻¹¹ S/cm ce qui reste environ de six ordres de grandeur plus faible que la conductivité ionique, c'est-à-dire d'un ordre de grandeur tout à fait acceptable pour les applications visées au stockage d'électricité.

Suivant la même abscisse, la figure 4 montre l'évolution de la composition de l'électrolyte.

## Revendications

1. Électrolyte solide (4) comprenant au moins une couche exempte d'azote et qui comprend du LiₓPO_{y}S_{z} avec 0< z ≤ 3, 2.1 ≤ x ≤ 2.4 et 1 ≤ y ≤ 4, déterminables par XPS (Spectroscopie Photoélectronique à rayons X) couplée avec une abrasion GCIB (Gas Cluster Ion Beam).

2. Electrolyte solide selon la revendication précédente, dans lequel la couche consiste en du LiₓPO_{y}S_{z} avec 0 < z ≤ 3.

3. Electrolyte solide (4) selon l'une des deux revendications précédentes, dans lequel z ≤ 2.

4. Electrolyte solide (4) selon l'une des revendications précédentes, dans lequel 3.7 ≤ y +z ≤ 4.1, et de préférence y + z = 4.

5. Electrolyte (4) selon l'une des revendications précédentes, comprenant au moins une couche tampon sur au moins une face de la au moins une couche de LiₓPO_{y}S_{z}.

6. Electrolyte (4) selon la revendication précédente, dans lequel la au moins une couche tampon comprend du LiPON.

7. Electrolyte (4) selon l'une des deux revendications précédentes, comprenant une couche tampon sur chaque face de la au moins une couche de LiₓPO_{y}S_{z}.

8. Batterie comprenant un électrolyte (4) selon l'une des revendications précédentes.

9. Batterie selon la revendication précédente, comprenant en empilement sur une face d'un substrat (1) :
- un premier collecteur de courant (6),
- une première électrode (2),
- l'électrolyte (4),
- une deuxième électrode (3),
- un deuxième collecteur de courant (7) et une ou plusieurs couches d'encapsulation.

10. Procédé de réalisation d'un électrolyte (4) selon l'une quelconque des revendications 1 à 7, comprenant une étape de dépôt physique en phase vapeur d'une couche d'électrolyte à partir d'une cible de Li₃PO₄ pulvérisée sous atmosphère comprenant au moins un gaz soufré, de manière à obtenir une couche comprenant du LiₓPO_{y}S_{z}.

11. Procédé selon la revendication précédente, dans lequel le gaz soufré est du H₂S.

12. Procédé selon l'une des deux revendications précédentes, dans lequel le taux de gaz soufré dans l'atmosphère est compris entre 0.5 et 15%, et est avantageusement inférieur ou égal à 10% voire à 5%.

13. Procédé selon l'une des trois revendications précédentes, dans lequel on utilise une atmosphère exempte d'azote.

14. Utilisation de LiₓPO_{y}S_{z} en absence d'azote, avec 0 < z ≤ 3, 2.1 ≤ x ≤ 2.4 et 1 ≤ y ≤ 4, déterminables par XPS (Spectroscopie Photoélectronique à rayons X) couplée avec une abrasion GCIB (Gas Cluster Ion Beam), pour la réalisation d'un électrolyte solide.

## Patentansprüche

1. Festkörperelektrolyt (4), umfassend wenigstens eine Schicht, frei von Stickstoff und die LiₓPO_{y}S_{z} mit 0 < z ≤ 3, 2,1 ≤ x ≤ 2,4 und 1 ≤ y ≤ 4 umfasst, bestimmbar mittels XPS (Röntgenphotoelektronenspektroskopie), gekoppelt mit einem GCIB-Abrieb (Gascluster-Ionenstrahl).

2. Festkörperelektrolyt nach dem vorstehenden Anspruch, wobei die Schicht aus LiₓPO_{y}S_{z} mit 0 < z ≤ 3 besteht.

3. Festkörperelektrolyt (4) nach einem der zwei vorstehenden Ansprüche, wobei z ≤ 2.

4. Festkörperelektrolyt (4) nach einem der vorstehenden Ansprüche, wobei 3,7 ≤ y + z ≤ 4,1 und vorzugsweise y + z = 4.

5. Elektrolyt (4) nach einem der vorstehenden Ansprüche, umfassend wenigstens eine Pufferschicht auf wenigstens einer Seite der wenigstens einen Schicht aus LiₓPO_{y}S_{z}.

6. Elektrolyt (4) nach dem vorstehenden Anspruch, wobei die wenigstens eine Pufferschicht LiPON umfasst.

7. Elektrolyt (4) nach einem der zwei vorstehenden Ansprüche, umfassend eine Pufferschicht auf jeder Seite der wenigstens einen Schicht aus LiₓPO_{y}S_{z}.

8. Batterie, umfassend einen Elektrolyt (4) nach einem der vorstehenden Ansprüche.

9. Batterie nach dem vorstehenden Anspruch, umfassend in einem Stapel auf einer Seite eines Substrats (1):
- einen ersten Stromableiter (6),
- eine erste Elektrode (2),
- den Elektrolyt (4),
- eine zweite Elektrode (3),
- einen zweiten Stromableiter (7) und eine oder mehrere Verkapselungsschichten.

10. Verfahren zur Herstellung eines Elektrolyten (4) nach einem der Ansprüche 1 bis 7, umfassend einen Schritt der physikalischen Gasphasenabscheidung einer Elektrolytschicht ausgehend von einem Target aus Li₃PO₄, zerstäubt unter einer Atmosphäre, umfassend wenigstens ein schwefelhaltiges Gas, um eine Schicht, umfassend LiₓPO_{y}S_{z}, zu erhalten.

11. Verfahren nach dem vorstehenden Anspruch, wobei das schwefelhaltige Gas H₂S ist.

12. Verfahren nach einem der zwei vorstehenden Ansprüche, wobei der Anteil des schwefelhaltigen Gases in der Atmosphäre zwischen 0,5 und 15 % beträgt und vorteilhafterweise kleiner oder gleich 10 % oder sogar 5 % ist.

13. Verfahren nach einem der drei vorstehenden Ansprüche, wobei eine Atmosphäre frei von Stickstoff verwendet wird.

14. Verwendung von LiₓPO_{y}S_{z} in Abwesenheit von Stickstoff, mit 0 < z ≤ 3, 2,1 ≤ x ≤ 2,4 und 1 ≤ y ≤ 4, bestimmbar mittels XPS (Röntgenphotoelektronenspektroskopie), gekoppelt mit einem GCIB-Abrieb (Gascluster-Ionenstrahl), für die Herstellung eines Festkörperelektrolyten.

## Claims

1. Solid electrolyte (4) comprising at least one nitrogen-free layer and that comprises LiₓPO_{y}S_{z}, with 0< z ≤ 3, 2.1 ≤ x ≤ 2.4 and 1 ≤ y ≤ 4, which can be determined by XPS (X-ray Photoelectron Spectroscopy) coupled with a GCIB (Gas Cluster Ion Beam) abrasion.

2. Solid electrolyte according to the preceding claim, wherein the layer consists of LiₓPO_{y}S_{z}, with 0 < z ≤ 3.

3. Solid electrolyte (4) according to one of the two preceding claims, wherein z ≤ 2.

4. Solid electrolyte (4) according to one of the preceding claims, wherein 3.7 ≤ y +z ≤ 4.1, and preferably y + z = 4.

5. Electrolyte (4) according to one of the preceding claims, comprising at least one buffer layer on at least one face of the at least one layer of LiₓPO_{y}S_{z}.

6. Electrolyte (4) according to the preceding claim, wherein the at least one buffer layer comprises LiPON.

7. Electrolyte (4) according to one of the two preceding claims, comprising a buffer layer on each face of the at least one layer of LiₓPO_{y}S_{z},

8. Battery comprising an electrolyte (4) according to one of the preceding claims.

9. Battery according to the preceding claim, comprising as a stack on one face of a substrate (1):
- a first current collector (6),
- a first electrode (2),
- the electrolyte (4),
- a second electrode (3),
- a second current collector (7) and one or more encapsulation layers.

10. Method for producing an electrolyte (4) according to any of claims 1 to 7, comprising a physical vapour deposition step of an electrolyte layer from a target of Li₃PO₄ sprayed under an atmosphere comprising at least one sulphur gas, in such a way as to obtain a layer comprising LiₓPO_{y}S_{z}.

11. Method according to the preceding claim, wherein the sulphur gas is H₂S.

12. Method according to one of the two preceding claims, wherein the sulphur gas content in the atmosphere is comprised between 0.5 and 15%, and is advantageously less than or equal to 10% even 5%.

13. Method according to one of the three preceding claims, wherein a nitrogen-free atmosphere is used.

14. Usage of LiₓPO_{y}S_{z} in the absence of nitrogen, with 0 < z ≤ 3, 2.1 ≤ x ≤ 2.4 and 1 ≤ y ≤ 4, which can be determined by XPS (X-ray Photoelectron Spectroscopy) coupled with a GCIB (Gas Cluster Ion Beam) abrasion, for the production of a solid electrolyte.
